# EUROPEAN PATENT SPECIFICATION

(11) **EP 0 572 075 B1**
(45) Date of publication and mention of the grant of the patent: **05.08.1998**
(21) Application number: 93201444.2
(22) Date of filing: 19.05.1993
(51) Int. Cl.: G01R 33/56

(54) **Method and apparatus for magnetic resonance imaging**
Verfahren und Gerät zur Bilderzeugung mittels magnetischer Resonanz
Procédé et appareil pour l'imagerie par résonance magnétique

(30) Priority: 27.05.1992 EP 92201513
(43) Date of publication of application: 01.12.1993
(73) Proprietor: Philips Electronics N.V., 5621 BA Eindhoven (NL)
(72) Inventor: van Yperen, Gerrit Hendrik, NL-5656 AA Eindhoven (NL)
(74) Representative: Schouten, Marcus Maria

(56) References cited:
- EP-A- 0 175 184
- DE-A- 4 035 410
- US-A- 4 893 081
- US-A- 5 068 609
- US-A- 5 099 208

## Description

The invention relates to a method for magnetic resonance imaging of a body placed in a stationary and substantially homogeneous main magnetic field, the method comprising
- the application of an excitation radio-frequency pulse (RF-pulse) for excitation of nuclear dipole moments in at least a portion of the body,
- the application of a plurality of refocusing RF-pulses following said excitation RF-pulse and of gradient magnetic fields for generating magnetic resonance signals comprising position dependent information,
- the measurement of magnetic resonance signals which follow at least a number of said refocusing RF-pulses. The invention also relates to an apparatus for magnetic resonance imaging using such a method. Such a sequence of RF-pulses is, for example, the known CPMG-sequence (Carr-Purcell-Meiboom-Gill sequence) which generates multiple nuclear magnetic resonance echo signals (NMR-signals) following the refocusing RF-pulses.

Such a method for imaging is known from EP-A-0 175 184. As indicated in that document, a selection of a portion of the body is made by the application of a gradient magnetic field during the application of the excitation RF-pulse. This results in the excitation of a slice of the body in which slice the Larmor frequency of a selected nucleus type in the magnetic field corresponds to the frequency of the RF-pulse. The slice selection gradient magnetic field is also applied during application of the refocusing RF-pulses. For position determination of the magnetic resonance signals, a gradient magnetic field with the gradient in a first direction within the slice is applied in the interval between the refocusing RF-pulses and the measurements of the nuclear magnetic resonance (NMR) signals for phase encoding of the NMR-signals. During the measurement a second gradient magnetic field, with its gradient in a second direction within the slice and perpendicular to the first direction provides frequency encoding of the NMR-signals.

In case a volume is selected as the excited portion of the body, a slice selection gradient may be absent during the RF-pulses. In addition to first and second gradient magnetic fields, a third gradient magnetic field with its gradient perpendicular to the first and second gradient magnetic fields is applied in between the RF-pulses and the measurements of the NMR-signals for additional phase encoding in that direction.

A disadvantage of such a sequence is that, due to spin-spin relaxation, the T₂-decay, the magnitude of the spin-echo signals decreases. So, contributions from the same region of the body portion are measured as signals of different size. In the resulting image, this leads to undesirable image errors such as blurring and ringing artefacts. As the total measured signal contains contributions of substances with different T₂ value, removal of the artefacts by weighting the signals with a time dependent weight is not possible.

It is an object of the invention to provide a magnetic resonance method in accordance to the introductory paragraph in which artefacts due to the T₂-decay are significantly reduced. Thereto, the method according to the invention is characterised in that the method comprises the generation of

two sequences of RF-pulses and gradients for obtaining MR-signals, a first sequence comprising phase encoding gradients in a first order, a second sequence comprising phase encoding gradients in a second order, the sum of the time interval between the excitation RF-pulse and the occurrence of a magnetic resonant signal with a given phase-encoding gradient in the first sequence and the time interval between the excitation RF-pulse and the occurence of a magnetic resonance signal with said given phase-encoding gradient in the second sequence being substantially equal for each phase encoding gradient setting. Several magnetic resonance signals with identical position information encoded into them are measured and the sum of the time intervals from the excitation RF-pulse to each of the measurements is equal for all sets of measurements with identical position encoding. As all measurements enter into the image reconstruction process, the effects of T₂-decay upon the resulting image are significantly reduced.

A preferred embodiment is characterised in that said first sequence comprises linearly decreasing phase encoding gradients, said second sequence comprises linearly increasing phase encoding gradients. The effect of such position encoded magnetic resonance signals is that it provides a simple way in which the invented method can be used, ensuring the equal total time condition.

In an embodiment of the magnetic resonance method comprising the execution of a plurality of first and second sequences, MR-signals are measured in said first and second sequences. In this embodiment the position dependency of the magnetic resonance signal is imposed as phase encoding of the precessing nuclear dipole moments. In accordance with the invention this embodiment is characterised in that the same phase encoding value occurs in a first sequence in an odd rank number and in a second sequence in an even rank number. Due to imperfections in the RF-pulses and switched gradient magnetic fields, a deviation may occur in the phase encoding values. The refocusing RF-pulses cause the phase deviation to be reflected, thereby causing, in first order, the deviation within a sequence to act as an alternation with the rank number. In this embodiment the measurements are supplemented by providing at each phase encoding value an additional measurement in which the deviation has the opposite sign. The effects of the deviation in the phase encoding values is thereby mitigated. A more detailed description of this effect can be found in the simultaneously filed European application No. 93201443.4 (EP-A-0 572 074).

The invention also relates to an apparatus for performing such a method. Such an apparatus for magnetic resonance imaging of a body placed in a stationary and substantially homogeneous main magnetic field comprises means for establishing the main magnetic field, means for generating gradient magnetic fields superimposed upon the main magnetic field, means for radiating RF-pulses towards a body placed in the main magnetic field, control means for steering the generation of the gradient magnetic fields and the RF-pulses, and means for receiving and sampling magnetic resonance signals generated by sequences of RF-pulses and switched gradient magnetic fields, said control means being arranged for
- applying an excitation radio-frequency pulse (RF-pulse) for excitation of nuclear dipole moments in at least a portion of the body,
- applying a plurality of refocusing RF-pulses following said excitation RF-pulse and gradient magnetic fields for generating position dependent magnetic resonance signals in the excited portion,
- measurement of magnetic resonance signals which follow at least a number of said refocusing RF-pulses. According to the invention it is further arranged for generating two sequences of RF-pulses and gradients for obtaining MR-signals, a first sequence comprising phase encoding gradients in a first order, a second sequence comprising phase encoding gradients in a second order, the sum of the time interval between the excitation RF-pulse and the occurrence of a magnetic resonant signal with a given phase-encoding gradient in the first sequence and the time interval between the excitation RF-pulse and the occurence of a magnetic resonance signal with said given phase-encoding gradient in the second sequence being substantially equal for each phase encoding gradient setting.

These, and other more detailed aspects of the invention will now be elucidated by way of example with reference to the accompanying drawings.

The drawings show in
Figure 1 diagrammatically a magnetic resonance imaging apparatus, suitable for the method according to the invention;
Figure 2 a sequence of an excitation RF-pulse, a plurality of refocusing RF-pulses, gradient magnetic fields and the occurrence of NMR-signals as a function of time;
Figures 3a and 3b a sequence and an equivalent sequence of RF-pulses and gradient magnetic fields according to the invention, respectively;
Figures 4a and 4b the relative T₂-decay of a single sequence and of two sequences combined according to the invention; and in
Figures 5a and 5b the central part of the modulus of the point spread function for a single sequence and for two sequences combined according to the invention.

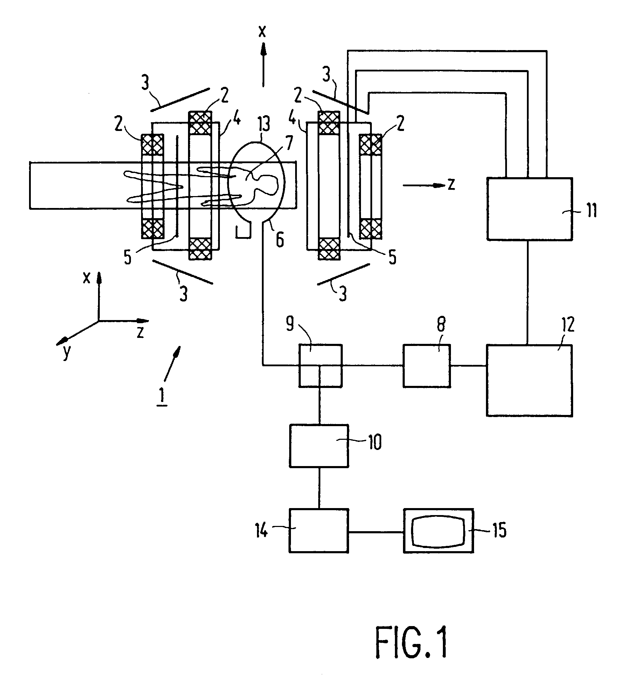

In Figure 1 a magnetic resonance apparatus 1 is diagrammatically shown. The apparatus comprises a set of main magnetic coils 2 for generating a stationary homogeneous main magnetic field and several sets of gradient coils 3, 4 and 5 for superimposing additional magnetic fields with controllable strength and having a gradient in a selected direction. Conventionally, the direction of the main magnetic field is labelled the *z* direction, the two directions perpendicular thereto the *x* and *y* directions. The gradient coils are energised *via* a power supply 11. The apparatus further comprises emitting means 6 for emitting radio-frequency pulses (RF-pulses) to an object or body 7, the radiation means being coupled to modulating means 8 for generating and modulating of the RF-pulses. Also provided are means for receiving the NMR-signals, these means can be identical to the emitting means 6 or be separate. If the emitting and receiving means are identical, as shown in the figure, a send-receive switch 9 is arranged to separate the received signals from the pulses to be emitted. The received NMR-signals are input to receiving and demodulating means 10. The emitting means 6 and 8 and the power supply 11 for the gradient coils 3, 4 and 5 are steered by a control system 12 to generate a predetermined sequence of RF-pulses and gradient field pulses. The demodulation means is coupled to a data processing unit 14, for example a computer, for transformation of the received signals into an image that can be made visible, for example on a visual display unit 15.

If the magnetic resonance apparatus 1 is put into operation with an object or body 7 placed in the magnetic field, a small excess of nuclear dipole moments (nuclear spins) in the body will be aligned in the direction of the magnetic field. In equilibrium, this causes a net magnetisation **M**_{**0**} in the material of the body 7, directed in parallel with the magnetic field. In the apparatus 1 the macroscopic magnetisation **M**_{**0**} is manipulated by radiating to the body RF-pulses having a frequency equal to the Larmor frequency of the nuclei, thereby bringing the nuclear dipole moments in an exited state and re-orienting the magnetisation **M**_{**0**}**.** By applying the proper RF-pulses, a rotation of the macroscopic magnetisation is obtained, the angle of rotation is called the flip-angle. The introduction of variations in the magnetic field by applying gradient magnetic fields influences the behaviour of the magnetisation locally. After the application of RF-pulses, the changed magnetisation will strive to return to a state of thermal equilibrium in the magnetic field, emitting radiation in the process. A well chosen sequence of RF-pulses and gradient field pulses causes this radiation to be emitted as NMR-signals which provide information about the density of a certain type of nuclei, for example hydrogen nuclei, and the substance in which they occur. By analysis of the emitted signals and presentation of it in the form of images, information about the internal structure of the object or body 7 is accessible. For a more detailed descriptions of magnetic resonance imaging (MRI) and MRI-devices reference is made to the extensive literature on this subject, for example to the book "Practical NMR Imaging", edited by M.A. Foster and J.M.S. Hutchinson, 1987, IRL Press.

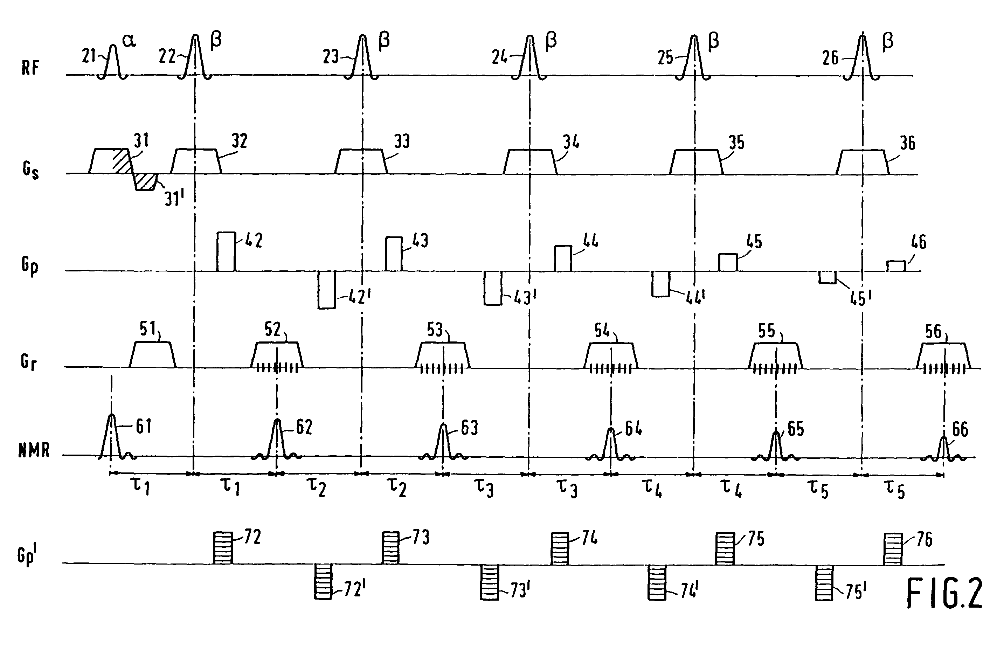

Figure 2 shows a known sequence of RF-pulses and magnetic field gradients for obtaining multiple spin-echo NMR-signals following a single excitation pulse. In the upper line RF the start of the sequence is indicated with an excitation RF-pulse RF-pulse 21 having a flip-angle α, followed after an interval τ₁ by a first refocusing 22 having a flip-angle β. Normally, the values of α and β are 90° and 180°, respectively. Following the excitation RF-pulse 21, a free induction decay (FID) nuclear magnetic resonance signal 61, indicated on the lower line NMR, is generated which dies out rapidly when the individual precessing nuclear magnetic dipole moments lose phase coherence due to local variations in the magnetic field. The refocusing RF-pulse 22 reverses the direction of these individual magnetic dipole moments without affecting the local magnetic field. Consequently, the dephasing is reversed into a rephasing resulting after an equal interval τ₁ in the occurrence of a NMR spin-echo signal 62. After the spin-echo signal 62 the dipole moments dephase again. Repetition of refocusing RF-pulses 23, 24, 25 and 26 cause subsequent reversals of the dephasing and the repeated occurrence of NMR spin-echo signals 63, 64, 65 and 66. Due to non-compensated effects, mainly spin-spin relaxation with a time constant T₂, the magnitude of subsequent echoes decreases in time. The interval lengths τ₂, τ₃, τ₄ and τ₅ between an NMR-signal and the next refocusing RF-pulse are normally chosen to be equal in length.

The effect of the RF-pulses is made selective to a portion of the body 7 by applying, simultaneously with the RF-pulses a slice selection gradient, which is indicated on the second line Gₛ in the figure. As indicated by 31 the slice selection gradient is first applied during the excitation RF-pulse 21. The dephasing caused by this first gradient 31 is compensated by an opposite gradient 31'. Also during the application of the refocusing RF-pulses 22-26 slice selection gradients 32-36 are switched on. For position determination within the selected slice, phase encoding gradient pulses 42,43, 44, 45 and 46 with the gradient direction within the selected slice, indicated on the third line Gₚ, are applied in the interval between the RF-pulse and the NMR spin-echo signals 62, 63, 64, 65 and 66. In addition, frequency encoding or read gradients 52, 53, 54, 55 and 56, indicated on the fourth line Gᵣ, having a gradient direction also within the selected slice but perpendicular to the gradient direction of the phase encoding field, are switched on during the occurrence of the spin-echo signals. The dephasing effects of the phase encoding gradients is removed after the occurrence of the spin-echo signals by applying further gradient field pulses 42', 43', 44', 45' with the same time-integrated size but with the gradient direction opposite compared to the preceding gradient pulses 42, 43, 44, 45, respectively. The dephasing effect of the read gradients 52, 53, 54, 55 and 56 is compensated for by the refocusing RF-pulses. An initial dephasing gradient 51 preceding the first refocusing RF-pulse 22 is then necessary, this initial dephasing gradient 51 has half the time-integrated size of the read gradients 52, 53, 54, 55 and 56.

Alternatively, not a slice but a volume portion of the body can be selected. In that case the slice selection gradient Gₛ may be absent or adopted for selection of a thick section of the body. In addition to the mentioned gradient fields, a second phase encoding gradient magnetic field Gₚ, is applied having a gradient direction perpendicular to the gradient directions of the first phase encoding field Gₚ and the read gradient field Gᵣ. Like the first phase encoding field Gₚ , this second gradient encoding field is applied as a series of gradient pulses 72, 73, 74, 75, 76, following the RF-pulses and compensating gradient pulses 72', 73', 74', 75', following the NMR-signals. As indicated by horizontal lines in gradient pulses 72-76 and 72'-76', the size of the second phase encoding gradient pulses are kept constant when the first phase encoding gradient pulses are varied. Alternatively, the first phase encoding gradient pulses 42-46 and 42'-45' may be kept constant and the second phase encoding gradient pulses be varied within a sequence. Hereinafter, the embodiments of the invention are described in the two-dimensional slice selection mode. However, extension to three-dimensional volume imaging by the application of a second phase encoding field is possible as well.

After acquisition of the NMR-signals, for example 256 spin-echo signals each with a different phase encoding value and each sampled 256 times, the total set of measurements is converted into an image by means of a Fourier transform (FT). As a consequence of the previously mentioned T₂-decay the NMR-signals occurring later in the sequence have a lower amplitude than the earlier signals. As a signal contains contributions of regions with different T₂ values, compensation by increasing the relative weight of the later signals in not possible. The T₂-deeay causes blurring and ringing artefacts in the resulting image.

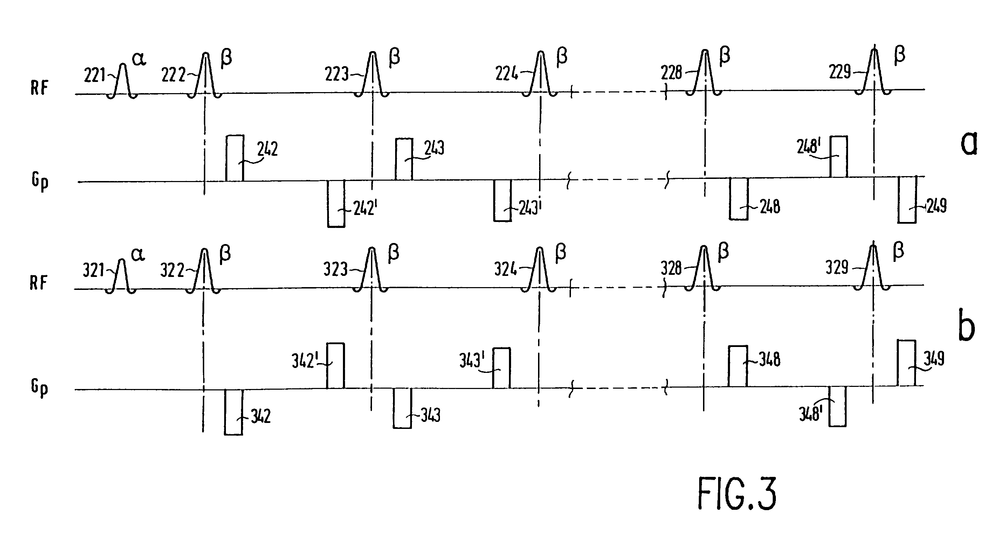

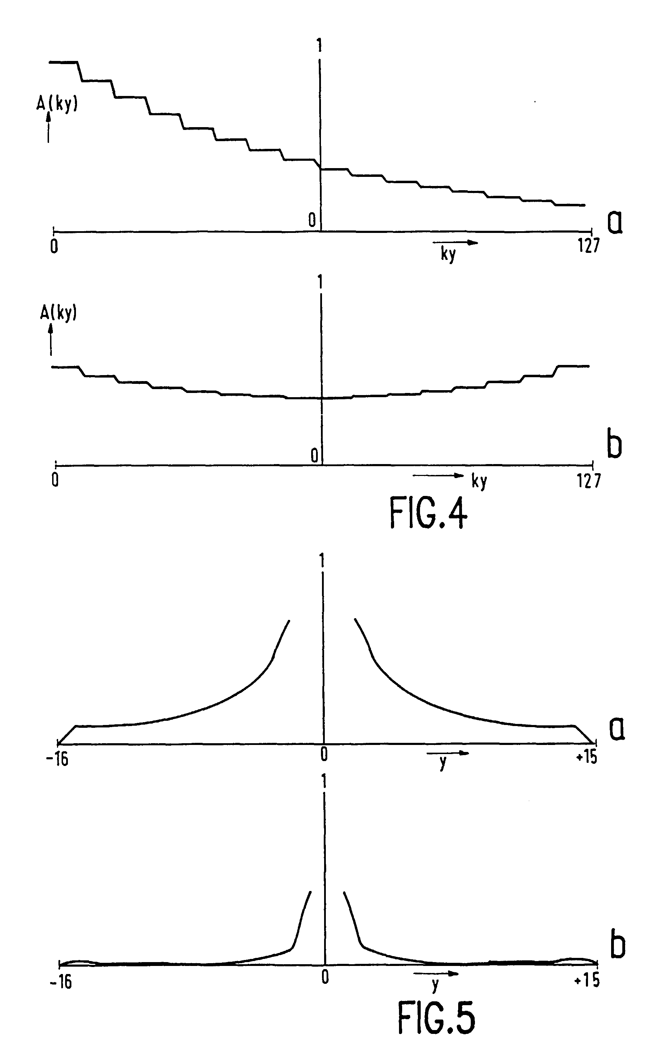

In figures 3a and 3b, two sequences of RF-pulses and gradient magnetic field pulses for obtaining NMR-signals according to the invention are shown. With the exception of the phase encoding gradient Gₚ, the sequences are identical with the sequence shown in figure 2 and only the Gₚ gradients and the RF-pulses are shown. The first and last few RF-pulses and accompanying gradient pulses are indicated only. The sequence of phase encoding gradient pulses 242, 243, ..., 248 and 249, shown in figure 3a is linearly decreasing. The sequence of figure 3b has linearly increasing phase encoding gradient pulses 342, 343, ..., 348 and 349, the phase encoding in the two chains being time reversed copies of each other. After executing both sequences there are two measurements for each phase encoding value. The sum of the time interval between excitation RF-pulse 221 and the measurement with a given phase encoding value in the first sequence, with the time interval between excitation RF-pulse 321 and the measurement with the same phase encoding value in the second sequence is the same for each phase encoding value. In figures 4a and 4b the relative T₂-decay A(T₂) of a single sequence and of two combined time-reversed sequences is shown as a function of the phase encoding value k_{y}, for 128 different phase encoding values determined in a series of interleaved sequences. As expected, the combined time reversed sequence shows much less amplitude variation. Using both measurements in the image reconstruction procedure reduces the blurring and artefacts due to T₂-decay considerably.

As mentioned hereinbefore, imperfections in the RF-pulses and the switched gradient magnetic fields, the latter mainly due to eddy currents, cause deviations or offsets in the phases of precession of the nuclear spins. Due to the refocusing RF-pulses the deviations, in first order, alternate with the spin-echo signals. If the two sequences of measurements for the same set of phase encoding values have an even number of refocusing RF-pulses, for each phase encoding one of the two measurements follows an RF-pulse with an even and one with an odd rank number. As the phase deviation is in first order alternating with the rank number, the effect of the two measurements is that the errors largely cancel.

In figures 5a and 5b the central part of the modulus of the point spread function (PSF(y)) is shown for a single set of measurements and for a combination of two sets, time-reversed relative to each other with an even number of phase encoding values. PSF(y) is mathematically the Fourier transform of a signal e^{iφ}, in which φ(k_{y}) is the phase deviation, and indicates the contribution of a point in the body to the resulting image. The figure is determined with φ(k_{y}) alternating between +20° and -20°. As can be seen, the combination of two time-reversed sequences leads to a considerable narrower PSF(y). This indicates that artefacts and blurring due to the phase deviations and T₂-decay are largely removed in the resulting image. Investigation of the real and imaginary parts, not shown, of PSF(y) reveals that the imaginary part of PSF(y) is strongly reduced.

## Claims

1. Method for magnetic resonance imaging of a body placed in a stationary and substantially homogeneous main magnetic field, the method comprising
- the application of an excitation radio-frequency pulse called RF-pulse for excitation of nuclear dipole moments in at least a portion of the body,
- the application of a plurality of refocusing RF-pulses following said excitation RF-pulse and of slice selection gradients, phase encoding gradients and frequency encoding gradients for generating magnetic resonance signals comprising position dependent information,
- the measurement of magnetic resonance signals which follow at least a number of said refocusing RF-pulses,
characterised in that the method comprises the generation of
two sequences of RF-pulses and gradients for obtaining MR-signals, a first sequence comprising phase encoding gradients in a first order, a second sequence comprising phase encoding gradients in a second order, the sum of the time interval between the excitation RF-pulse and the occurrence of a magnetic resonant signal with a given phase encoding gradient in the first sequence and the time interval between the excitation RF-pulse and the occurence of a magnetic resonance signal with said given phase encoding gradient in the second sequence being substantially equal for each phase encoding gradient setting.

2. Method according to claim 1, characterised in that said first sequence comprises linearly decreasing phase encoding gradients, said second sequence comprises linearly increasing phase encoding gradients.

3. Method according to claim 1 or 2, comprising the execution of a plurality of first and second sequences, wherein MR-signals are measured in said first and second sequences, characterised in that the same phase encoding value occurs in a first sequence in an odd rank number and in a second sequence in an even rank number.

4. Apparatus for magnetic resonance imaging of a body (7) placed in a stationary and substantially homogeneous main magnetic field according to a method as claimed in any of the preceding claims, the apparatus comprising means for establishing the main magnetic field (2), means for generating gradient magnetic fields (3,4,5) superimposed upon the main magnetic field, means (6,8) for radiating RF-pulses towards a body (7) placed in the main magnetic field, control means (12) for steering the generation of the slice selection gradients, the phase encoding gradients, the frequency encoding gradients and the RF-pulses, and means for receiving (6,10) and sampling magnetic resonance signals generated by sequences of RF-pulses and switched gradient magnetic fields, said control means (12) being arranged for
- applying an excitation RF-pulse for excitation of nuclear dipole moments in at least a portion of the body,
- applying a plurality of refocusing RF-pulses following said excitation RF-pulse and gradient magnetic fields for generating position dependent magnetic resonance signals in the excited portion,
- measurement of magnetic resonance signals which follow at least a number of said refocusing RF-pulses,
characterised in that
said control means being further arranged for generating two sequences of RF-pulses and gradients for obtaining MR-signals, a first sequence comprising phase encoding gradients in a first order, a second sequence comprising phase encoding gradients in a second order, the sum of the time interval between the excitation RF-pulse and the occurrence of a magnetic resonant signal with a given phase encoding gradient in the first sequence and the time interval between the excitation RF-pulse and the occurence of a magnetic resonance signal with said given phase encoding gradient in the second sequence being substantially equal for each phase encoding gradient setting.

## Patentansprüche

1. Verfahren zur Kernresonanzabbildung eines in ein stationäres und nahezu homogenes Hauptmagnetfeld eingebrachten Körpers, wobei das Verfahren umfaßt
- das Anlegen eines Anregungshochfrequenzimpulses, HF-Impuls genannt, zur Anregung von Kerndipolmomenten in zumindest einem Teil des Körpers,
- das Anlegen einer Vielzahl von refokussierenden HF-Impulsen, die dem genannten Anregungs-HF-Impuls folgen, und von Schichtselektionsgradienten, Phasencodierungsgradienten und Frequenzcodierungsgradienten zum Generieren von Kernresonanzsignalen mit positionsabhängiger Information,
- die Messung von Kernresonanzsignalen, die zumindest einer Anzahl der genannten refokussierenden HF-Impulse folgen,
dadurch gekennzeichnet, daß das Verfahren die Erzeugung von
zwei Sequenzen von HF-Impulsen und Gradienten zum Erhalten von MR-Signalen umfaßt, eine erste Sequenz mit Phasencodierungsgradienten in einer ersten Ordnung, eine zweite Sequenz mit Phasencodierungsgradienten in einer zweiten Ordnung, wobei die Summe aus dem Zeitintervall zwischen dem Anregungs-HF-Impuls und dem Auftreten eines Kernresonanzsignals mit einem gegebenen Phasencodierungsgradienten in der ersten Sequenz und dem Zeitintervall zwischen dem Anregungs-HF-Impuls und dem Auftreten eines Kernresonanzsignals mit dem genannten gegebenen Phasencodierungsgradienten in der zweiten Sequenz für jede Phasencodierungsgradienteneinstellung nahezu gleich ist.

2. Verfahren nach Anspruch 1, dadurch gekennzeichnet. daß die genannte erste Sequenz linear abnehmende Phasencodierungsgradienten umfaßt und die genannte zweite Sequenz linear zunehmende Phasencodierungsgradienten umfaßt

3. Verfahren nach Anspruch 1 oder 2, das die Ausführung einer Vielzahl von ersten und zweiten Sequenzen umfaßt, wobei MR-Signale in diesen ersten und zweiten Sequenzen gemessen werden, dadurch gekennzeichnet, daß der gleiche Phasencodierungswert in einer ersten Sequenz in einer ungeraden Rangnummer und in einer zweiten Sequenz in einer geraden Rangnummer auftritt.

4. Gerät zur Kernresonanzabbildung eines in ein stationäres und nahezu homogenes Hauptmagnetfeld eingebrachten Körpers (7) gemäß einem Verfahren nach einem der vorhergehenden Ansprüche, wobei das Gerät Mittel zum Aufbauen des Hauptmagnetfeldes (2), Mittel zum Erzeugen von dem Hauptmagnetfeld überlagerten Gradientenmagnetfeldern (3,4,5), Mittel (6,8) zum Abstrahlen von HF-Impulsen hin zu einem in das Hauptmagnetfeld eingebrachten Körper (7), Steuerungsmittel (12) zum Ansteuern der Erzeugung der Schichtselektionsgradienten, der Phasencodierungsgradienten, der Frequenzcodierungsgradienten und der HF-Impulse, und Mittel zum Empfangen (6,10) und Abtasten von Kernresonanzsignalen, die von Sequenzen von HF-Impulsen und geschalteten Gradientenmagnetfeldern generiert worden sind, wobei die genannten Steuerungsmittel (12) ausgebildet sind, um
- einen Anregungs-HF-Impuls zur Anregung von Kerndipolmomenten in zumindest einem Teil des Körpers anzulegen,
- eine Vielzahl von refokussierenden HF-Impulsen, die dem genannten Anregungs-HF-Impuls folgen, sowie Gradientenmagnetfelder zum Generieren positionsabhängiger Kernresonanzsignale in dem angeregten Teil anzulegen,
- Kernresonanzsignale zu messen, die zumindest einer Anzahl dieser refokussierenden HF-Impulse folgen,
dadurch gekennzeichnet, daß
die genannten Steuerungsmittel weiterhin ausgebildet sind, um zwei Sequenzen von HF-Impulsen und Gradienten zum Erhalten von MR-Signalen zu generieren, eine erste Sequenz mit Phasencodierungsgradienten in einer ersten Ordnung, eine zweite Sequenz mit Phasencodierungsgradienten in einer zweiten Ordnung, wobei die Summe aus dem Zeitintervall zwischen dem Anregungs-HF-Impuls und dem Auftreten eines Kernresonanzsignals mit einem gegebenen Phasencodierungsgradienten in der ersten Sequenz und dem Zeitintervall zwischen dem Anregungs-HF-Impuls und dem Auftreten eines Kernresonanzsignals mit dem genannten gegebenen Phasencodierungsgradienten in der zweiten Sequenz für jede Phasencodierungsgradienteneinstellung nahezu gleich ist.

## Revendications

1. Procédé pour former par résonance magnétique l'image d'un corps placé dans un champ magnétique principal statique et sensiblement homogène, le procédé comprenant,
- l'application d'une impulsion de radiofréquence d'excitation dite impulsion RF pour l'excitation de moments dipolaires nucléaires dans au moins une partie du corps,
- l'application d'une pluralité d'impulsions RF de refocalisation succédant à l'impulsion RF d'excitation et de gradients de sélection de tranche, de gradients de codage de phase et de gradients de codage de fréquence pour engendrer des signaux de résonance magnétique comprenant des informations dépendantes de la position,
- la mesure de signaux de résonance magnétique qui succèdent au moins à un certain nombre de ces impulsions RF de refocalisation,
caractérisé en ce que le procédé comprend la génération de deux séquences d'impulsions de radiofréquence et de gradients pour obtenir des signaux de résonance magnétique, une première séquence comprenant des gradients de codage de phase dans un premier ordre, une deuxième séquence comprenant des gradients de codage de phase dans un deuxième ordre, la somme de l'intervalle de temps entre l'impulsion de radiofréquence d'excitation et l'apparition d'un signal de résonance magnétique avec un gradient de codage de phase donné dans la première séquence et de l'intervalle de temps entre l'impulsion de radiofréquence d'excitation et l'apparition d'un signal de résonance magnétique avec ledit gradient de codage de phase donné dans la deuxième séquence étant sensiblement égale pour chaque réglage de gradient de codage de phase.

2. Procédé suivant la revendication 1, caractérisé en ce que la première séquence comprend des gradients de codage de phase à décroissance linéaire et la deuxième séquence comprend des gradients de codage de phase à croissance linéaire.

3. Procédé suivant la revendication 1 ou 2, comprenant l'exécution d'une pluralité de premières et deuxièmes séquences, dans lequel des signaux de résonance magnétique sont mesurés dans ces premières et deuxièmes séquences, caractérisé en ce que la même valeur de codage de phase apparaît dans une première séquence dans un numéro de rang impair et dans une deuxième séquence dans un numéro de rang pair.

4. Appareil pour former par résonance magnétique l'image d'un corps (7) placé dans un champ magnétique principal statique et sensiblement homogène conformément à un procédé suivant l'une quelconque des revendications précédentes, l'appareil comprenant des moyens pour établir le champ magnétique principal (2), des moyens pour engendrer les champs magnétiques de gradients (3, 4, 5) superposés au champ magnétique principal, des moyens (6, 8) pour émettre des impulsions de radiofréquence vers un corps (7) placé dans le champ magnétique principal, des moyens de commande (12) pour piloter la génération des gradients de sélection de tranche, des gradients de codage de phase, des gradients de codage de fréquence, des gradients de codage de fréquence et des impulsions de radiofréquence, et des moyens pour recevoir (6, 10) et échantillonner des signaux de résonance magnétique engendrés par les séquences d'impulsions de radiofréquence et de champs magnétiques de gradients commutés, ces moyens de commande (12) étant agencés pour
- l'application d'une impulsion de radiofréquence d'excitation en vue de l'excitation de moments dipolaires nucléaires dans au moins une partie du corps,
- l'application d'une pluralité d'impulsions de radiofréquence de refocalisation succédant à l'impulsion de radiofréquence d'excitation et aux champs magnétiques de gradients pour engendrer des signaux de résonance magnétique dépendant de la position dans la partie excitée,
- la mesure de signaux de résonance magnétique qui succèdent à au moins un certain nombre des impulsions de radiofréquence de refocalisation,
caractérisé en ce que ces moyens de commande sont, en outre, conçus pour engendrer deux séquences d'impulsions de radiofréquence et de gradients pour obtenir des signaux de résonance magnétique, une première séquence comprenant des gradients de codage de phase dans un premier ordre, une deuxième séquence comprenant des gradients de codage de phase dans un deuxième ordre, la somme de l'intervalle de temps entre l'impulsion de radiofréquence d'excitation et l'apparition d'un signal de résonance magnétique avec un gradient de codage de phase donné dans la première séquence et de l'intervalle de temps entre l'impulsion de radiofréquence d'excitation et l'apparition d'un signal de résonance magnétique avec ce gradient de codage de phase donné dans la deuxième séquence étant sensiblement égale pour chaque réglage de gradient de codage de phase.
